# EUROPEAN PATENT APPLICATION

(11) **EP 3 252 978 A1**
(43) Date of publication of application: **06.12.2017**
(21) Application number: 16305636.9
(22) Date of filing: 01.06.2016
(51) Int. Cl.: H04L 1/06, H04L 1/22, H04W 40/02, H04L 12/707

(54) **APPARATUSES, METHODS AND COMPUTER PROGRAMS FOR TRANSMITTING OR RECEIVING PAYLOAD DATA AND PAYLOAD RECOVERY DATA**

(71) Applicant: ALCATEL LUCENT, 92100 Boulogne-Billancourt (FR)
(72) Inventor: KUCERA, Stepan, 70435 Stuttgart (DE); BUDDHIKOT, Milind M, 70435 Stuttgart (DE)
(74) Representative: 2SPL Patentanwälte PartG mbB

(57) **Abstract**

Embodiments of the present invention relate to apparatuses (10; 20), methods and computer programs for transmitting or receiving payload data. Embodiments provide an apparatus (10), configured to transmit payload data using a first wireless data channel and information related to payload recovery data using a second wireless data channel. The apparatus 10 comprises at least one interface (12) configured to communicate via the first wireless data channel and via the second wireless data channel. The apparatus (10) further comprises a control module (14) configured to control the at least one interface (12). The control module (14) is further configured to obtain the payload data. The control module (14) is further configured to determine the information related to payload recovery data based on the payload data. The control module (14) is further configured to transmit the payload data via the at least one interface (12) and the first wireless data channel and the information related to payload recovery data via the at least one interface (12) and the second wireless data channel.

## Description

Embodiments of the present invention relate to apparatuses, methods and computer programs for transmitting or receiving payload data and payload recovery data, more precisely, but not exclusively, based on transmitting or receiving payload data via a first wireless data channel and information related to payload recovery data via a second wireless data channel.

### Background

Wireless networks have made progress over the years: As more and more users use wireless networks to check e-mails, visit social networks and consume and share media, data transmission rates of wireless networks have risen significantly. For many users, such wireless access is the main means of communication and information, and access to such networks has risen in both popularity and importance. Services that run on top of the wireless networks, e.g. via the internet, instead of via dedicated services of phone providers, have led of a multitude of applications, from internet-based messengers to having access to home security systems, from location-based cab-hailing to live streaming of user videos.

A number of applications that run on top of the wireless networks may have requirements as to the properties of the networks: Streaming services may require a minimum data transmission rate, while phone calls over the internet (e.g. via a Voice over Internet Protocol, VoIP) rely on continuous transmission with a reduced maximum delay. Applications that require near-real time responses and interactions, e.g. steering and control of real and virtual objects, remote traffic control of self-driving cars and drones, closed-loop control of industrial processes, or gaming may require a reduction of delays in transmissions for such applications.

More information can be found in:
D. J. C. MacKay: Fountain codes;
Jay Kumar Sundararajan et al.: Network Coding Meets TCP: Theory and Implementation.
Mohammad Karzand, Douglas Leith: Low Delay Random Linear Codes over Streams;
Ali Begen, David Oran: Forward error correction based data recovery with path diversity, US 2009 201805 A1; and
Milind Madhav Buddhikot, Lance Hartung; Policy Driven Multi-band Spectrum Aggregation for Ultra-broadband Wireless Networks.

### Summary

At least some embodiments relate to apparatuses, methods and computer programs for transmitting payload data. An apparatus for transmitting such payload data may be configured to communicate via a first wireless data channel, e.g. via a Long Term Evolution (LTE) mobile communication system or a mobile communication system of the 5^{th} generation (5G) and via a second wireless data channel, e.g. via a public WiFi (Wireless Fidelity) network. Both wireless data channels, taken separately, might not be able to achieve connections having a low delay, as they may be influenced by rapidly changing wireless conditions and may be shared with a multitude of users. Embodiments may be based on using a wireless data channel, e.g. the first wireless data channel, for transmitting payload data, and using the other (or multiple others) channel to transmit forward error correction data, to make up for lost and delayed packets and to avoid costly re-transmissions. Embodiments may provide a next generation ultra-low delay wireless access using supplemental bandwidth, e.g. on the second wireless data channel.

According to a first aspect of the present invention, an apparatus is configured to transmit payload data using a first wireless data channel and information related to payload recovery data using a second wireless data channel. The apparatus comprises at least one interface configured to communicate via the first wireless data channel and via the second wireless data channel. The apparatus further comprises a control module configured to control the at least one interface. The control module is further configured to obtain the payload data. The control module is further configured to determine the information related to payload recovery data based on the payload data. The control module is further configured to transmit the payload data via the at least one interface and the first wireless data channel and the information related to payload recovery data via the at least one interface and the second wireless data channel. Transmitting the payload data and the information related to the payload recovery data (e.g. Forward Error Correction (FEC) data) via separate channels enables forward error correction while keeping a reduced amount of data transmitted on the first wireless data channel. At least some embodiments may further enable error correction without re-transmissions and additional delay due to disturbances on one of the channels.

In various embodiments, the control module may be further configured to determine buffer-related information of a network entity, e.g. a base station transceiver or a gateway, configured to communicate via the first wireless data channel. The control module 14 may be further configured to transmit the payload data based on the buffer-related information of the network entity. Transmitting the payload data based on the buffer-related information (e.g. information related to a buffer state) may enable a more continuous data transmission, as re-transmissions due to buffer overflows in the network entities may be reduced or avoided.

In at least some embodiments, the control module may be configured to adapt a transmission rate for transmitting the payload data based on the buffer-related information of the network entity. Adapting the transmission rate of the payload data based on the buffer-related information may enable a more continuous data transmission, as re-transmissions due to buffer overflows in the network entities may be reduced or avoided.

In various embodiments, the first wireless data channel may be a subscription-based wireless data channel. The subscription-based wireless data channel may provide a higher data transmission capacity for the subscription user, for example. The second wireless data channel may be a subscription-free wireless data channel. The subscription-free wireless data channel may add additional capacity for the payload recovery data, but might provide less reliable data transmissions than the first wireless data channel, for example.

In at least some embodiments, the payload data may comprise one or more payload packets. The control module may be configured to determine one or more payload recovery packets for the information related to the payload recovery data. A payload recovery packet may comprise data recovery information for at least one payload packet. Using a payload recovery packet to recover at least one (e.g. at least two, at least three, at least four, at least 8) payload packet may enable a lower data transmission rate on the second wireless data channel and may enable a compromise between data transmission rate and redundancy.

In various embodiments, the control module may be configured to determine the one or more payload recovery packets based on a weighted random linear combination of the one or more payload packets or based on a logic function based on the one or more payload packets. Using the weighted random liner combination or a logic function enables an on-the-fly generation of the payload recovery packets.

In at least some embodiments, the control module may be configured to determine information related to in-line payload recovery data based on the payload data. The control module may be configured to transmit the information related to the in-line payload recovery data via the at least one interface on the first wireless data channel. The control module may be configured to adapt a quantity of the information related to the payload recovery data and/or a quantity of the information related to the in-line payload recovery based on the information related to the in-line payload recovery data. Adding further payload recovery data may further enhance a recoverability of data packets, e.g. while using available bandwidth on the first wireless data channel.

In at least some embodiments, the control module may be configured to transmit the information related to the payload recovery data if a traffic indicator of the second wireless data channel indicates an availability of data channel bandwidth for the transmission of the information related to the payload recovery data, e.g. if a traffic rate is below a traffic threshold or if an expected end-to-end-delay is below a delay threshold. If the traffic indicator does not indicate the availability of data channel bandwidth, additional delay may be incurred on the second wireless data channel, which may reduce an efficiency of the data recovery.

In various embodiments, the control module may be configured to transmit the information related to the payload recovery data if the first wireless data channel and the second wireless data channel use at least partly different transmission resources (e.g. wireless resources). Using the same transmission resources might reduce an overall efficiency, as the transmission of the information related to the payload recovery data may delay or impede the transmission of the payload data.

In at least some embodiments, the at least one interface may comprise a first wireless interface, configured to communicate via the first wireless data channel and a second wireless interface, configured to communicate via the second wireless data channel. The control module may be configured to transmit the payload data via the first wireless interface and to transmit the information related to the payload recovery data via the second wireless interface. Transmitting the payload data and the information related to the payload recovery data via different interfaces may enable using the forward error correction via different channels in a mobile device, e.g. a smartphone.

Alternatively or additionally, the control module may be configured to transmit the payload data and the information related to the recovery data via a common data channel to a gateway connected to the first wireless data channel and the second wireless data channel. Transmitting the payload data and the information related to the payload recovery data via a common data channel may enable controlling the forward error correction from a network entity (e.g. a content server) not directly connected to the first and second wireless data channels.

In various embodiments, the control module may be configured to switch the transmission of the payload data to the second wireless data channel and the transmission of the information related to the payload recovery data to the first wireless data channel based on transmission properties of the first wireless data channel and based on transmission properties of the second wireless data channel. For example, the control module may be configured to switch the transmission if the second wireless data channel may provide a more continuous transmission of data and/or if a transmission delay on the second wireless data channel is lower than on the first wireless data channel.

Embodiments further provide an apparatus configured to receive payload data using a first wireless data channel and information related to payload recovery data using a second wireless data channel. The apparatus comprises at least one interface, configured to receive the payload data via the first wireless data channel and the information related to the payload recovery data via the second wireless data channel. The payload data comprises one or more payload packets. The apparatus further comprises a control module, configured to control the at least one interface. The control module is further configured to check the payload data for missing or delayed payload packets. The control module is further configured to recover the missing or delayed packets of the payload data based on the information related to the payload recovery data. Transmitting the payload data and the information related to the payload recovery data (e.g. Forward Error Correction (FEC) data) via separate channels enables forward error correction while keeping a reduced amount of data transmitted on the first wireless data channel. At least some embodiments may further enable error correction without re-transmissions and additional delay due to disturbances on one of the channels.

In various embodiments, the information related to the payload recovery data may comprises one or more payload recovery packets. The control module may be configured to recover at least one missing or delayed payload packet of the one or more payload packets based on the one or more payload recovery packets. Using a payload recovery packet to recover at least one (e.g. at least two, at least three, at least four, at least 8) may enable a lower data transmission rate on the second wireless data channel and may enable a compromise between data transmission rate and redundancy.

In at least some embodiments, the one or more payload recovery packets may be based on a weighted random linear combination of the one or more payload packets. The control module may be configured to recover the at least one missing or delayed payload packet based on a Gaussian elimination based on the one or more payload packets and based on the one or more payload recovery packets. The Gaussian elimination may enable a recovery based on a reduced number and packets and a reduced buffer size.

In various embodiments, the control module may be configured to determine if the first wireless data channel and the second wireless data channel use the same transmission resources (e.g. wireless resources) based on time-correlated packet losses on the first wireless data channel and the second wireless data channel. The control module may be configured to transmit information related to a usage of the same transmission resources to a sender of the payload data and the information related to the payload recovery data if the first wireless data channel and the second wireless data channel use the same transmission resources. Using the same transmission resource might reduce an overall efficiency, as the transmission of the information related to the payload recovery data may delay the transmission of the payload data. Transmitting the information related to the usage of the same transmission resource may enable the sender to adjust the transmission of the payload data and/or of the information related to the payload recovery data.

Embodiments further provide a method for transmitting payload data using a first wireless data channel and information related to payload recovery data using a second wireless data channel. The method comprises obtaining the payload data. The method further comprises determining the information related to payload recovery data based on the payload data. The method further comprises transmitting the payload data via the first wireless data channel and the information related to payload recovery data via the second wireless data channel.

Embodiments further provide a method for receiving payload data using a first wireless data channel and information related to payload recovery data using a second wireless data channel. The method comprises receiving the payload data via the first wireless data channel. The payload data comprises one or more payload packets. The method further comprises receiving the information related to the payload recovery data via the second wireless data channel. The method further comprises checking the payload data for missing or delayed payload packets. The method further comprises recovering the missing or delayed packets of the payload data based on the information related to the payload recovery data.

Some embodiments comprise a digital control circuit installed within the apparatus for performing the method. Such a digital control circuit, e.g. a digital signal processor (DSP), needs to be programmed accordingly. Hence, yet further embodiments also provide a computer program having a program code for performing embodiments of one of the method, when the computer program is executed on a computer or a digital processor.

### Brief description of the Figures

Some embodiments of apparatuses and/or methods will be described in the following by way of example only, and with reference to the accompanying figures, in which
- Fig. 1: illustrates a block diagram of an embodiment of an apparatus for transmitting payload data;
- Fig. 1a: illustrates a block diagram of a further embodiment of an apparatus for transmitting payload data;
- Fig. 2a: shows an example of spatial diversity;
- Fig. 2b: shows a diagram of an encoding redundancy concept;
- Fig. 2c: shows a schematic representation of Transmit Control Protocol probing of a wireless channel having time-varying capacity with indicated buffer overflows;
- Fig. 2d: shows a diagram of a cumulative probability density function of block sizes re-ordered in live macro-cell and small-cell networks;
- Fig. 3: illustrates a block diagram of an embodiment of an apparatus for receiving payload data;
- Fig. 3a: illustrates a block diagram of a further embodiment of an apparatus for receiving payload data;
- Fig. 4a: illustrates a formation of forward error correction packets using random linear codes;
- Fig. 4b: illustrates a recovery of a delayed payload packet using forward error correction packets;
- Fig. 4c: shows a diagram of a data re-ordering delay as function of forward packet-level protection overhead as measured in live small-cell LTE deployments for static and mobile users;
- Fig. 4d: shows a further diagram of a data re-ordering delay as function of forward packet-level protection overhead as measured in live small-cell LTE deployments for static and mobile users;
- Fig. 4e: shows an illustrative diagram of a payload data transmission via two data channels;
- Fig. 4f: shows a diagram of an exemplary distribution of payload packets on transmission resources of two data channels;
- Fig. 4g: shows a diagram of an embodiment of intra-flow data recovery of payload packets;
- Fig. 4h: shows a diagram of an embodiment of inter-flow data recovery of payload packets;
- Fig. 5: illustrates a flow chart of an embodiment of a method for transmitting payload data; and
- Fig. 6: illustrates a flow chart of an embodiment of a method for receiving payload data.

### Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

Cellular networks, now using the 4th generation (4G) LTE standard, have evolved over the years to offer increasingly greater per-user data rate and impressive gains in system capacity. Current 4G networks support notions of Quality of Service (QoS) in the form of multiple degrees of data bearer quality, characterized by pre-selected soft targets for bit error rate and scheduling priority. However, they may lack support for a further reduced delay and tight latency control and therefore might not support many new age applications targeted for 5th generation (5G) wireless networks such as steering and control of real and virtual objects (Tactile Internet), remote 3D graphical rendering for virtual/augmented-reality overlay, remote traffic control of self-driving cars and drones, closed-loop control of industrial processes, and gaming.

Design of such wireless access with a reduced delay is a hard problem as the link delay is impacted by many parameters such as:
▪ rapid fluctuations in the wireless channel due to change in signal strength, (co/adjacent-channel) interference and user mobility
▪ variable delay effects of medium access contention, data traffic congestion, queuing, re-transmissions, as well as out-of-order delivery due to buffer overflows.

Given support for a reduced latency is one of the key capabilities required for the 5th Generation Wireless Access, novel technologies that can enable this capability are required.

The 4G LTE standard for cellular networking may enable QoS-characterized connections by introducing multiple degrees of data bearer quality, characterized by pre-selected soft targets for bit error rate and scheduling priority. Yet given the unresolved unreliability of wireless links, current technology might only be capable of service differentiation and prioritization.

Attempts to control data delivery latency may be hampered by protocols that recover lost or intolerably delayed data by means of end-to-end retransmissions. Yet reactive re-transmissions may perceptibly increase data delivery delay (at least 1.5x of the connection round-trip time, i.e. transmission-to-acknowledgment time). Moreover, a throughput drop may follow re-transmissions in TCP implementations with the standard loss-based congestion control. Delay-wise more efficient pro-active re-transmissions of unacknowledged data without explicit receiver feedback may, on the other hand, be difficult to configure correctly due to variance of link properties (e.g. time-varying buffer backlog) - too low or high time-out threshold results in either high overhead or missed data delivery deadlines, respectively.

Fountain codes for multicast applications could be used to avoid the need for re-transmissions in general but they are characterized by unfavorable latency profile due to block-wise data delivery as well as introduce challenges related to transmitter-receiver coordination. Low-latency streaming codes relying on the serial (e.g., periodical) interleaving of payload data with forward-error correction data may alleviate the issue of time-wise discontinuous delivery but are ineffective in case of link outages, typical in wireless channels. Also, this strategy might not be useable to protect TCP (Transmission Control Protocol), representing over 80% of the Internet traffic - the TCP standard may require that any delayed or missing data has to be re-transmitted, so unnecessary re-transmissions of missing or delayed forward-error correction data may undesirably cause blocking of payload data transmissions.

At least some embodiments may be based on spatial diversity, encoding redundancy, and/or buffer state control.

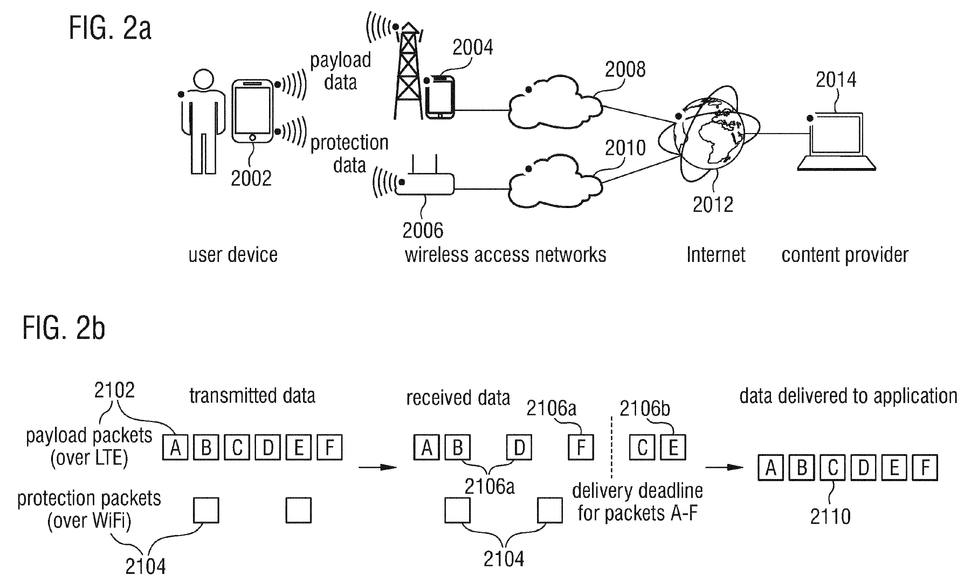

Spatial diversity refers to the delivery of a data flow over multiple parallel wireless links / paths (e.g. a first wireless data channel and a second wireless data channel), see Fig. 2a. Fig. 2a shows a spatial diversity example - a primary latency-sensitive LTE transmission is protected by forward-error correction data delivered over a parallel WiFi connection (e.g. free of charge). A user device 2002 is connected to a first base station transceiver 2004 using a first wireless data channel and to a second base station transceiver 2006 using a second wireless data channel. The base station transceivers 2004; 2006 are connected to network entities 2008; 2010, which, along with the base station transceivers 2004; 2006, are comprised in wireless access networks, which are connected via the internet 2012 to a server 2014 of a content provider. An outage in multiple independent paths simultaneously is much less likely than individual single-path outages. Modern mobile devices, such as smart phones and tablets, may already support multi-technology multi-band networking: they are often equipped with multiple LTE, HSPA (High Speed Packet Access), WiFi transceivers operational in multiple licensed and unlicensed frequency bands. Moreover, a new 5G interface as well as allocation of new (shared) frequency bands can be expected in the near future.

Spatial diversity may already be used for inter-network load balancing and coverage optimization purposes and is increasingly available, e.g. due to ongoing network densification by small-cell deployments. It may be used as a common mode of communications for next-generation mm-wave links that may be particularly prone to outages caused by propagation-obstructing clutter, or simply the user body.

Encoding redundancy refers to the injection of additional protection data into the actual flow of service (payload) data to compensate for unavoidable errors or outages of the wireless links. In the latency control context, one idea may be to establish Forward Error Correction (FEC), e.g. Forward Packet Loss Protection (FPLP), against packet loss that allows recovering lost or unacceptably delayed payload data without re-transmissions before an application-required delivery deadline expires, see Fig. 2b. A trivial examples may be to replicate the payload data flow over each parallel path; embodiments may provide more efficient approaches. Fig. 2b shows a diagram of an encoding redundancy concept - missing or intolerably delayed payload data may be recovered from forward-error correction data without re-transmission delays and related throughput reductions. An implementation may be based on random linear codes, for example. In Fig. 2b, payload packets A-F 2102 and protection packets 2104 are transmitted, e.g. via LTE and WiFi, respectively. At the receiver end, payload packets A, B, D and F 2106a arrive in time, but payload packets C, E 2106b are past a delivery deadline, while the protection packets 2104 arrive on time. The protection packets 2104 may be used to restore the sequence 2110.

The FEC scalability may be further exploited not only for payload data protection but also for network path probing to facilitate the tasks of path selection and scheduling. The scalability claim may be based on the approach that indefinite amount of FEC packets can be generated for a limited set of source packets assuming well-designed generator codes.

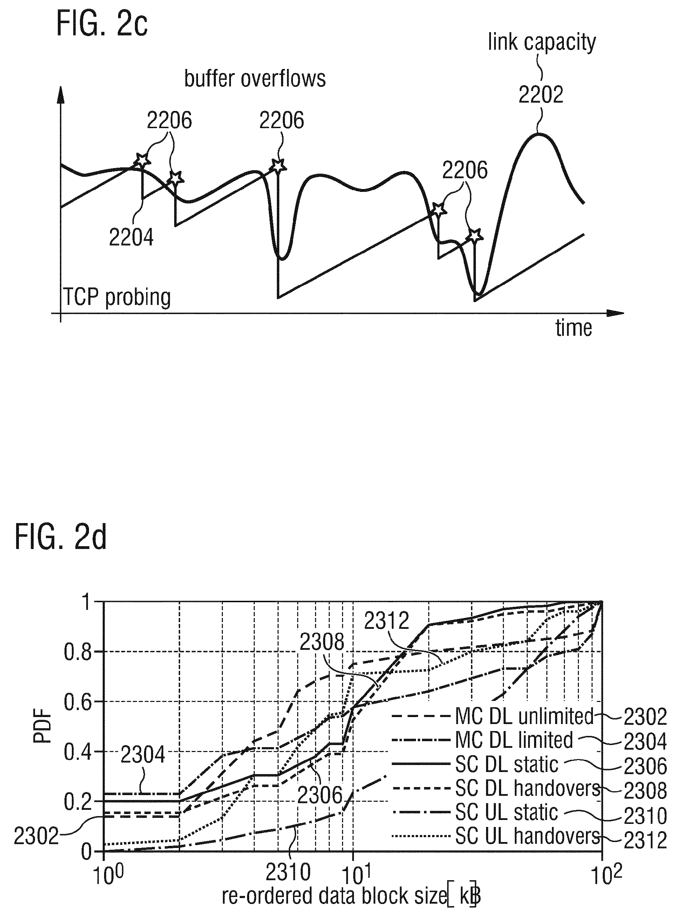

Buffer state control may refer to active monitoring and control of ingress buffer occupancy in the link bottleneck (typically wireless base stations in well-backhauled networks), e.g. for the first wireless data channel. One idea may be to prevent self-inflicted loss of data as a result of buffer overflow. These may be relatively common events as most of the Internet traffic relies nowadays on loss-based congestion control that adjusts the packet transmissions rate with respect to the maximum available channel capacity. To estimate the latter quantity, conventional systems (e.g. the Transmission Control Protocol, TCP) may be based on active channel probing, during which the number of in-flight packets is progressively increased until a buffer overflow occurs - a sign of a "full" channel, see Fig. 2c. Lost data may be re-transmitted, which may be detrimental for the delay reduction perspective.

Fig. 2c shows a schematic representation of TCP probing of a wireless channel having time-varying capacity with indicated buffer overflows (i.e., data loss followed by re-transmissions). In TCP probing, a data transmission rate of TCP packets 2204 is continuously increased, until a link capacity 2202 is reached. If the amount of data transmitted surpasses 2206 the link capacity 2202, packets are lost, the data transmission rate 2204 is severely reduced and packets are re-transmitted, which may be detrimental for a delay of the packets.

Measurements of live macro-cell as well as small-cell LTE networks may indicate that the self-inflicted but controllable damage from transport-layer probing is multiple orders higher compared to the possibly unavoidable physical and medium-access layers of the transport network. Fig. 2d shows that tens to hundreds of consecutive TCP packets (x-axis) may be lost due to TCP probing, while at most few packets may be lost at once within the LTE protocol stack. Hence, using buffer overflow prevention, the overhead of forward-error correction data may be reduced further. Fig. 2d shows a diagram of a cumulative probability density function (PDF) of block sizes re-ordered by TCP in live macro-cell (MC) and small-cell (SC) LTE networks. Fig. 2d 2302 shows the graph for a macro cell in downlink direction in unlimited setting, 2304 shows the graph for a macro cell in downlink direction in limited setting, 2306 shows the graph for a small cell in downlink direction with static mobile transceivers, 2308 shows the graph for a small cell in downlink direction with mobile transceivers in a handover, 2310 shows the graph for a small cell in uplink direction with static mobile transceivers, and 2312 shows the graph for a small cell in uplink direction with mobile transceivers in a handover.

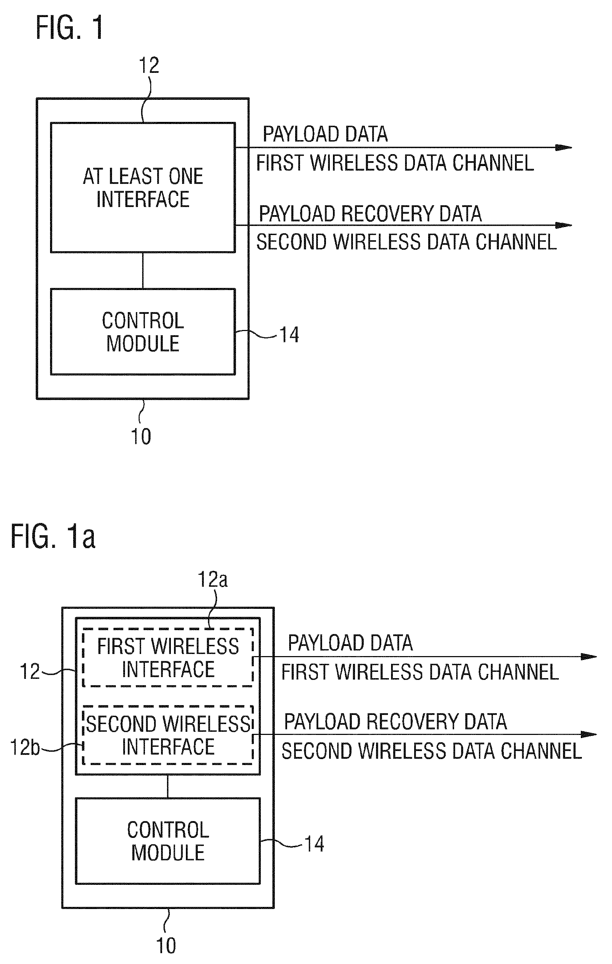

Fig. 1 illustrates a block diagram of an embodiment of an apparatus 10, configured to transmit payload data using a first wireless data channel and information related to payload recovery data using a second wireless data channel. The apparatus comprises at least one interface 12, configured to communicate via the first wireless data channel and via the second wireless data channel. The apparatus further comprises a control module 14 configured to control the at least one interface 12. The control module 14 is further configured to obtain the payload data. The control module 14 is further configured to determine the information related to payload recovery data based on the payload data. The control module 14 is further configured to transmit the payload data via the at least one interface 12 and the first wireless data channel and the information related to payload recovery data via the at least one interface 12 and the second wireless data channel.

In at least some embodiments, the first wireless data channel and/or the second wireless data channel may be based on a mobile communication system. For example, the first wireless data channel may be based on a first mobile communication system and the second wireless data channel may be based on a second mobile communication system. Alternatively, the first wireless data channel and the second wireless data channel may be based on the same mobile communication system comprising a first base station transceiver and second base station transceiver, and the first wireless data channel may be based on a wireless connection between a mobile transceiver and the first base station transceiver and the second wireless data channel may be based on a wireless connection between the mobile transceiver and the second base station transceiver (e.g. LTE dual connectivity). In an alternative implementation, the first mobile communication system may comprise the first base station transceiver and the second mobile communication system may comprise the second base station transceiver. Alternatively, the first wireless data channel and the second wireless data channel may be based on wireless connection to the same base station transceiver. The first wireless data channel may be based on a first carrier frequency range and the second wireless data channel may be based on a second carrier frequency range being different from the first carrier frequency range (e.g. using LTE inter- or intra-band carrier aggregation). In some embodiments, the first and/or second wireless data channels may be based on at least one of License Assisted Access (LAA), Boost, LTE-U (LTE in an unlicensed spectrum), 5G millimeter-wave transmissions and multi-path TCP for example.

In a preferred embodiment, the first wireless data channel and/or the second wireless data channel may correspond to established transport-layer sessions (e.g. TCP or UDP (User Datagram Protocol) sessions), for example. Within the established transport-layer sessions, data may be transmitted. Alternatively, the first wireless data channel and/or the second wireless data channel may correspond to at least portions of a physical channel. The physical channel may be characterized by at least one element of the group of a frequency resource used, a time resource used, a code resource used and a spatial resource used.

In various embodiments, the second wireless data channel may represent a plurality of second wireless data channels. For example, the control module 14 may be configured to transmit the information related to the payload recovery data on one or more wireless data channels of the plurality of second wireless data channels, e.g. on one wireless data channel of the plurality of second wireless data channels based on transmission properties on the one wireless data channel, on a subset of the plurality of second wireless data channels or on all of the plurality of second wireless data channel. The control module 14 may be configured to determine transmission properties of the plurality of second wireless data channels, and may be configured to transmit the information related to the payload recovery data based on the determined transmission properties, e.g. based on an average or minimum round-trip time of the wireless data channel, based on a reliability of the wireless data channel, based on a data throughput of the wireless data channel and/or based on a continuity of the wireless data channel.

For example, the first wireless data channel may be a subscription-based wireless data channel, e.g. based on UMTS (Universal Mobile Telecommunication System), LTE or 5G. The second wireless data channel may be a subscription-free wireless data channel, e.g. based on unlicensed spectrum, e.g. based on WiFi (e.g. based on WiFi offliading). Alternatively, both the first wireless data channel and the second wireless data channel may be a subscription-based wireless data channel being provided by different base station transceiver, e.g. based on UMTS, LTE or 5G.

For example, the first wireless data channel may be a connection-based wireless data channel (i.e., in-order TCP-like delivery with re-transmissions), e.g. for transmission of payload data subject to QoS requirements. The second wireless data channel may be a connection-less wireless data channel (i.e. best-effort UDP-like delivery without re-transmissions) for the transmission of the information related to the payload recovery data (FEC data). In at least some embodiments, the second wireless data channel may be based on best-effort data transmissions. In various embodiments, transmissions on the second wireless data channel are based on delay constraints, e.g. packets on the second wireless data channel may not arrive later than a delivery deadline, e.g. based on the transmission of the corresponding payload data. The first wireless data channel may correspond to a primary path, and the second wireless data channel may correspond to a secondary path. The second path and the first path may be independent, for example.

In various embodiments, the primary path may be characterized by subscription-based access, scheduled medium access, and/or private per-UE (User Equipment, e.g. a mobile transceiver)/bearer/application queuing (e.g., 3G HSPA and 4G LTE). The secondary path may be characterized by subscription-free access, random/contention-based medium access, and/or a shared queue (e.g., WiFi).

In at least some embodiments, the control module 14 may be configured to switch the transmission of the payload data to the second wireless data channel and the transmission of the information related to the payload recovery data to the first wireless data channel based on transmission properties of the first wireless data channel and based on transmission properties of the second wireless data channel. The control module 14 may be configured to switch the transmission based on a round-trip time of packets on the first wireless data channel and on the second wireless data channel, based on a reliability of the first wireless data channel and the second wireless data channel, based on a throughput of the first wireless data channel and the second wireless data channel and/or based on a continuity of the first wireless data channel and the second wireless data channel. For example, the control module 14 may be configured to choose a wireless data channel of the plurality of second wireless data channels to transmit the payload data,

The selection and scheduling of primary/secondary paths (first wireless data channel and second wireless data channel) may be based on the notion of round trip time (one-way forward delay). For example, the primary path may be the one with the lowest round trip time. The best secondary path (wireless data channel of the plurality of second wireless data channels) may become primary path (first wireless data channel), for example. To determine an improved path, FEC packets may be used to probe the quality of available secondary paths in terms of achievable capacity, delay, jitter. The control module 14 may be configured to adjust a number of payload recovery packets in the information related to the payload recovery data, e.g. increase the number, to determine transmission properties of the second wireless data channel (or the plurality of second wireless data channels). If necessary, the FEC overhead may be increased from the baseline minimum required for loss compensation to the amount required to support probing (determining transmission properties).

For example, a transmission rate of payload data over primary path may be improved for throughput subject to overflow prevention objectives. A transmission rate of FEC data over the secondary path may be improved for delay subject to in-time delivery with associated payload data.

In at least some embodiments, the primary path (first wireless data channel) may carry predefined (maximum) FEC overhead to compensate for PHY/MAC (Physical / Medium Access Control) losses (e.g., FEC overhead is determined based on events not leading to Congestion Windows (CWND) reduction). The FEC data may preferably be sent over a session parallel to the payload data session. The control module 14 may be configured to set the overhead to compensate for the average loss rate on the primary path. The secondary path may carry the remaining FEC overhead, used to cover for loss peaks. The control module 14 may be configured to transmit a portion of the information related to the payload recovery data via the first wireless data channel, for example, and the remainder of the information related to the payload recovery data via the second wireless data channel, for example.

In general, FEC data can be sent over any orthogonal link (second wireless data channel) that is independent from the primary payload link (first wireless data channel), for example. If such orthogonal links are already used for data transfer, then opportunistic usage of periods characterized by low link activity or buffer occupancy may be preferred to reduce the impact on the original data transfer. The control module 14 may be configured to transmit the information related to the payload recovery data based on a link activity and/or buffer occupancy of the second wireless data channel and/or the first wireless data channel, for example.

In at least some embodiments, the payload data may correspond to a cargo of a data transmission, for example. Data transmissions may comprise a overhead portion and a payload portion, for example. In various embodiments, the payload data and the information related to the payload recovery data may be comprised in a data transmission. The payload data may comprise the payload portion and a part of the overhead portion, and the information related to the payload recovery data may comprise a further part of the overhead portion, which may comprise FEC data, for example.

In various embodiments, the payload data may comprise one or more payload packets. The control module 14 may be configured to determine one or more payload recovery packets for the information related to the payload recovery data. A payload recovery packet may comprise data recovery information for at least one payload packet. For example, a payload packet may comprise recovery information for at least 2, at least 3, at least 4 or at least 8 payload data packets. For example, the control module 14 may be configured to determine a payload recovery packet of the one or more payload recovery packets based on a mathematical function based on at least 2, at least 3, at least 4 or at least 8 payload data packets, for example. In some embodiments, the control module 14 may be configured to determine the one or more payload recovery packets based on a weighted random linear combination of the one or more payload packets, for example. For example, the control module 14 may be configured to determine the one or more payload recovery packets based on a convolutional code, e.g. based on the Viterbi algorithm. Alternatively, the control module 14 may be configured to determine the one or more payload recovery packets based on a turbo code or based on a Low-Density Parity Check (LDPC) code, for example. Alternatively, the control module 14 may be configured to determine the one or more payload recovery packets based on a logic function (e.g. a logic combination or a linear function) based on the one or more payload packets, e.g. based on an exclusive-or (XOR) combination of two or more payload packets or based on a shift register. The control module 14 may be configured to determine the one or more payload recovery packets based on a forward error correction algorithm, for example. For example, the control module 14 may be configured to determine a payload recovery packet for every 2, every 3, every 4, every 8, every n payload packets etc., with n being an integer. In some embodiments, the payload packets and/or the payload recovery packets may correspond to TCP packets, for example. In some embodiments, a maximum size of a payload packet may differ by less than 10% from a maximum size of a payload recovery packet. For example, the size of a payload portion of a payload packet and of a payload recovery packet may be substantially the same. In some embodiments, the one or more payload recovery packets may correspond to UDP (User Datagram Protocol) packets.

In some embodiments, a mobile transceiver or a base station transceiver may comprise the apparatus 10. The control module 14 may be configured to obtain the payload data from a shared memory or as a data transmission, for example, e.g. via a further interface. As shown in Fig. 1a, the at least one interface 12 may comprise a first wireless interface 12a, configured to communicate via the first wireless data channel and a second wireless interface 12b, configured to communicate via the second wireless data channel. For example, the first wireless interface 12a may correspond to an interface for the first mobile communication system, and/or the second wireless interface 12b may correspond to an interface for the second mobile communication system. The control module 14 may be configured to transmit the payload data via the first wireless interface 12a and to transmit the information related to the payload recovery data via the second wireless interface 12b.

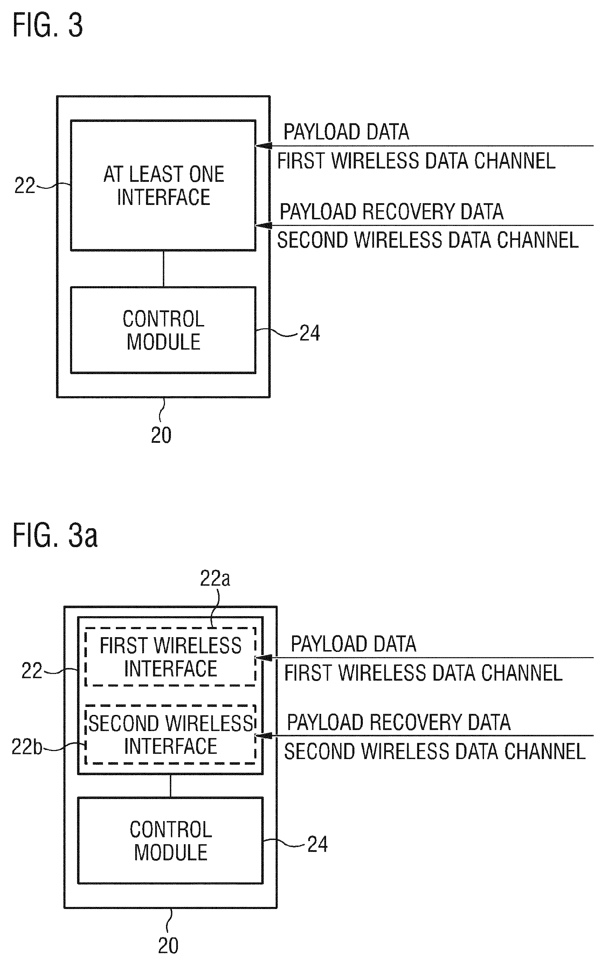

In at least some embodiments, the first wireless interface 12a and/or the second wireless interface 12b (and/or a first wireless interface 22a and/or a second wireless interface 22b of Fig. 3a) may be implemented as any means for transceiving, i.e. receiving and/or transmitting etc., one or more transceiver units, one or more transceiver devices and it may comprise typical receiver and/or transmitter components, such as one or more elements of the group of one or more Low-Noise Amplifiers (LNAs), one or more Power Amplifiers (PAs), one or more filters or filter circuitry, one or more diplexers, one or more duplexers, one or more Analog-to-Digital converters (A/D), one or more Digital-to-Analog converters (D/A), one or more modulators or demodulators, one or more mixers, one or more antennas, etc.

In at least some embodiments, a content server or network entity may comprise the apparatus 10. The control module 14 may be configured to read the payload data from a shared memory or to receive the payload data via inter-process communication or from a further network entity, e.g. a content server or gateway. The control module 14 may be configured to transmit the payload data and the information related to the recovery data via a common data channel to a gateway connected to the first wireless data channel and the second wireless data channel. For example, the control module 14 may be configured to transmit the payload data to a first base station transceiver transmitting on the first wireless data channel and the information related to the payload recovery data to a second base station transceiver transmitting on the second wireless data channel, e.g. via the gateway connected to the first wireless data channel and the second wireless data channel.

In at least some embodiments, the control module 14 may be further configured to determine buffer-related information of (related to) a network entity, e.g. a base station transceiver, a gateway or a router, configured to communicate via the first wireless data channel. The control module 14 may be further configured to transmit the payload data based on the buffer-related information of the network entity. The control module 14 may be configured to adapt a transmission rate for transmitting the payload data based on the buffer-related information of the network entity. For example, the control module 14 may be configured to receive the buffer-related information from the network entity, from a further network entity controlling the network entity or from a mobile transceiver receiving the payload data. Alternatively, the control module 14 may be configured to determine the buffer-related information based on a load factor or advertised receive window of the network entity, for example. In some embodiments, the control module 14 may be configured to determine the buffer-related information based on a previous transmission, for example, e.g. based on a prediction of a current buffer state based on previous transmissions or transmission statistics. For example, the buffer-related information may indicate at least one element of the group of a buffer state, a buffer size, a (predicted) buffer throughput, a buffer fill state and or a throughput of the network entity. The network entity may correspond to a base station, a gateway or a router configured to communicate via the first wireless data channel or to provide resources for the first wireless data channel, for example.

Buffer overflows may be reduced or prevented by transmit rate control on the primary path based on the feedback from the client and/or the network (e.g., delay-based congestion control on the server side, client-side limitations of the advertised receive window, monitoring of buffer occupancy in bottleneck base station, UE/network measurements and future expectations of delay and capacity).

In some embodiments, the control module may be configured to transmit the information related to the payload recovery data if a traffic indicator of the second wireless data channel indicates an availability of data channel bandwidth for the transmission of the information related to the payload recovery data, e.g. if a traffic rate of the second wireless data channel is below a traffic threshold. For example, the traffic indicator may comprise information related to a data delivery rate, a data loss rate, a queueing delay, or an end-to-end delay on the second wireless data channel. Advantageously, FEC data might only be sent when a usage of the second wireless data channel (WiFi usage) is lower than a minimum threshold, determined e.g. the control module 14 may be configured to determine the traffic rate based on input from the medium access layer or as queuing delay of IP probes and round-trip time of TCP ACKs. In general, a pre-determined amount of capacity of a given link can be filled with FEC data.

For example, the control module 14 may be configured to determine a transmission rate for the payload data based on an utilization of the first wireless data channel. The control module 14 may be configured to transmit the payload data based on the utilization of the first wireless data channel and/or the transmission rate for the payload data. Additionally or alternatively, the control module 14 may be configured to determine a transmission rate for the information related to the payload recovery data based on an utilization of the second wireless data channel. The control module 14 may be configured to transmit the information related to the payload recovery data based on the utilization of the second wireless data channel and/or the transmission rate for the information related to the payload recovery data.

In various embodiments, the control module 14 may be configured to transmit the information related to the payload recovery data if the first wireless data channel and the second wireless data channel use at least partly different transmission resources. For example, the control module 14 may be configured to receive information related to a usage of the same transmission resources (e.g. wireless resources) from a receiver of the payload data or a network entity en route to the receiver of the payload data, for example. For example, FEC data (the information related to the payload recovery data) might not be transmitted if primary and secondary paths (first and second wireless data channels) share a bottleneck, e.g. a wireless resource or a network entity providing less than a required data transmission bandwidth. Alternatively, the FEC overhead (information related to the payload recovery data) may be reduced to the level that is sufficient to cover basic PHY/MAC losses. The control module 14 may be configured to determine the information related to the payload recovery data (e.g. a granularity thereof) based on whether the first wireless data channel and the second wireless data channel share transmission (e.g. wireless) resources. Transmission resources may correspond to wireless resources (e.g. frequency resources, time resources, spatial resources, and/or code resources) or transmission resources on wireline networks imposing a bottleneck on data transmissions.

More specifically, in case of connection-oriented sessions such as TCP transfers (e.g. streaming video), payload data and FEC data (information related to the payload recovery data) may be sent over exclusive physical connections to avoid delay in payload data delivery due to missing FEC data - TCP delivers data in order, i.e. a packet might not be delivered until all previous packets have been received. Shared bottleneck detection may e.g. be used to avoid situations with WiFi being backhauled over LTE - a case of mobile WiFi access points onboard of transport vehicles.

The at least one interface 12 and/or at least one interface 22 of Fig. 3 may correspond to one or more inputs and/or outputs for receiving and/or transmitting information, which may be in digital (bit) values according to a specified code, within a module, between modules or between modules of different entities.

In embodiments the control module 14 and/or a control module 24 of Fig. 3 may be implemented using one or more processing units, one or more processing devices, any means for processing, such as a processor, a computer or a programmable hardware component being operable with accordingly adapted software. In other words, the described function of the control module 14; 24 may as well be implemented in software, which is then executed on one or more programmable hardware components. Such hardware components may comprise a general purpose processor, a Digital Signal Processor (DSP), a microcontroller, etc.

Fig. 3 illustrates a block diagram of an embodiment of an apparatus 20, configured to receive payload data using a first wireless data channel and information related to payload recovery data using a second wireless data channel. The apparatus 20 comprises at least one interface 22, configured to receive the payload data via the first wireless data channel and the information related to the payload recovery data via the second wireless data channel. The payload data comprises one or more payload packets. The apparatus 20 further comprises a control module 24, configured to control the at least one interface 22. The control module 24 is further configured to check the payload data for missing or delayed payload packets. The control module 24 may be configured to check for missing or delayed payload packets based on a sequence numbering of the one or more payload packets and/or based on a time-out counter based on time-stamps of received payload packets, for example. In some embodiments, the control module 14 may further be configured to check the received payload packets for damaged packets, e.g. based on a cyclic redundancy check.

The control module 24 is further configured to recover the missing or delayed (or damaged) packets of the payload data based on the information related to the payload recovery data. In at least some embodiments, the information related to the payload recovery data may comprise one or more payload recovery packets. The control module 24 may be configured to recover at least one missing or delayed (or damaged) payload packet of the one or more payload packets based on the one or more payload recovery packets. For example, the control module 24 may be configured to calculate a portion of payload data of the missing, delayed or damaged payload packet based on the one or more payload recovery packet, e.g. based on a Gaussian elimination or based on the Viterbi-algorithm.

In an exemplary embodiment, the one or more payload recovery packets may be based on a weighted random linear combination of the one or more payload packets. The control module 24 may be configured to recover the at least one missing or delayed payload packet based on a Gaussian elimination based on the one or more payload packets and based on the one or more payload recovery packets.

In at least some embodiments, the control module 24 may be configured to recover the at least one missing or delayed (or damaged) payload packet before a re-transmission of the at least one missing or delayed (or damaged) payload packet is triggered by a receiver of the payload data, for example, or before subsequent payload packets are provided.

The control module 24 may further be configured to provide the payload data to a subsequent network entity, to a shared memory or via inter process communication after the at least one missing or delayed (or damaged) payload packet has been recovered, for example.

In various embodiments, the control module 24 may be configured to determine if the first wireless data channel and the second wireless data channel use the same transmission (e.g. wireless or wireline) resources (e.g. those resources imposing a bottleneck on data transmissions) based on time-correlated packet losses on the first wireless data channel and the second wireless data channel. The control module 24 may be configured to transmit information related to a usage of the same transmission resources to a sender of the payload data and the information related to the payload recovery data if the first wireless data channel and the second wireless data channel use the same transmission resources.

In some embodiments, a mobile transceiver or a base station transceiver may comprise the apparatus 20 (and/or the apparatus 10 of Fig. 1). As shown in Fig. 3a, the at least one interface 22 may comprises a first wireless interface 22a, configured to communicate via the first wireless data channel and a second wireless interface 22b, configured to communicate via the second wireless data channel. For example, the first wireless interface 22a may correspond to an interface for the first mobile communication system, and/or the second wireless interface 22b may correspond to an interface for the second mobile communication system. The control module 24 may be configured to receive the payload data via the first wireless interface 22a and to receive the information related to the payload recovery data via the second wireless interface 22b.

In at least some embodiments, a content server or network entity may comprise the apparatus 20 (and/or the apparatus 10 of Fig 1). The control module 22 may be configured to receive the payload data and the information related to the recovery data via a common data channel from a gateway connected to the first wireless data channel and the second wireless data channel. For example, the control module 24 may be configured to receive the payload data from a first base station transceiver transmitting on the first wireless data channel and the information related to the payload recovery data from a second base station transceiver transmitting on the second wireless data channel, e.g. via the gateway connected to the first wireless data channel and the second wireless data channel.

Embodiments further provide a system, comprising a mobile transceiver comprising at least one of the apparatuses 10; 20 and a content server/network entity comprising at least one of the apparatuses 10; 20. The first wireless data channel and the second wireless data channel may correspond to at least portions of a data channel between the mobile transceiver and the content server/network entity.

The network entity may correspond to a base station transceiver, a gateway, a packet data gateway, a proxy server, a router, a bridge, or a load balancer, for example.

The first wireless data channel and/or the second wireless data channel may be based on a mobile communication system, for example. In general, the mobile communication system may, for example, correspond to one of the Third Generation Partnership Project (3GPP)-standardized mobile communication networks, where the term mobile communication system is used synonymously to mobile communication network. The mobile or wireless communication system may correspond to, for example, a 5th Generation system (5G), a Long-Term Evolution (LTE), an LTE-Advanced (LTE-A), High Speed Packet Access (HSPA), a Universal Mobile Telecommunication System (UMTS) or a UMTS Terrestrial Radio Access Network (UTRAN), an evolved-UTRAN (e-UTRAN), a Global System for Mobile communication (GSM) or Enhanced Data rates for GSM Evolution (EDGE) network, a GSM/EDGE Radio Access Network (GERAN), or mobile communication networks with different standards, for example, a Worldwide Inter-operability for Microwave Access (WIMAX) network IEEE 802.16 or Wireless Local Area Network (WLAN) IEEE 802.11, generally an Orthogonal Frequency Division Multiple Access (OFDMA) network, a Time Division Multiple Access (TDMA) network, a Code Division Multiple Access (CDMA) network, a Wideband-CDMA (WCDMA) network, a Frequency Division Multiple Access (FDMA) network, a Spatial Division Multiple Access (SDMA) network, etc.

A base station transceiver can be operable to communicate with one or more active mobile transceivers and a base station transceiver can be located in or adjacent to a coverage area of another base station transceiver, e.g. a macro cell base station transceiver or small cell base station transceiver. Hence, embodiments may provide a mobile communication system comprising one or more mobile transceivers and one or more base station transceivers, wherein the base station transceivers may establish macro cells or small cells, as e.g. pico-, metro-, or femto cells. A mobile transceiver may correspond to a smartphone, a cell phone, user equipment, radio equipment, a mobile, a mobile station, a laptop, a notebook, a personal computer, a Personal Digital Assistant (PDA), a Universal Serial Bus (USB) - stick, a car, a mobile relay transceiver for D2D communication, etc. A mobile transceiver may also be referred to as User Equipment (UE) or mobile in line with the 3GPP terminology.

A base station transceiver can be located in the fixed or stationary part of the network or system. A base station transceiver may correspond to a remote radio head, a transmission point, an access point, radio equipment, a macro cell, a small cell, a micro cell, a femto cell, a metro cell etc. A base station transceiver may correspond to a base station understood as a logical concept of a node/entity terminating a radio bearer or connectivity over the air interface between a terminal/mobile transceiver and a radio access network. A base station transceiver can be a wireless interface of a wired network, which enables transmission of radio signals to a UE or mobile transceiver. Such a radio signal may comply with radio signals as, for example, standardized by 3GPP or, generally, in line with one or more of the above listed systems. Thus, a base station transceiver may correspond to a NodeB, an eNodeB, a Base Transceiver Station (BTS), an access point, a remote radio head, a transmission point, a relay transceiver etc., which may be further subdivided in a remote unit and a central unit.

A mobile transceiver can be associated, camped on, or registered with a base station transceiver or cell. The term cell refers to a coverage area of radio services provided by a base station transceiver, e.g. a NodeB (NB), an eNodeB (eNB), a remote radio head, a transmission point, etc. A base station transceiver may operate one or more cells on one or more frequency layers, in some embodiments a cell may correspond to a sector. For example, sectors can be achieved using sector antennas, which provide a characteristic for covering an angular section around a remote unit or base station transceiver. In some embodiments, a base station transceiver may, for example, operate three or six cells covering sectors of 120° (in case of three cells), 60° (in case of six cells) respectively. A base station transceiver may operate multiple sectorized antennas. In the following a cell may represent an according base station transceiver generating the cell or, likewise, a base station transceiver may represent a cell the base station transceiver generates.

At least some embodiments may be based on congestion control, path management and/or scheduling. An illustrative embodiment may be based on trading supplemental bandwidth for a reduction of data delivery latency.

A mobile user requiring low-latency high-throughput (e.g., an interactive video stream) may activate multiple radio-access interfaces on its multi-interface and/or multi-band device to allocate supplemental bandwidth in at least two independent data delivery paths (e.g., LTE as primary link and WiFi as secondary link as shown in Fig. 2a). The control modules 14; 24 may be configured to activate the first and second wireless interfaces 12a; 12b; 22a; 22b for example.

The service server, i.e. a remote server for downloads or the user device itself for uploads, may be configured to generate FEC data associated with the actual payload data. The payload data may be delivered from server to client over the primary link while the FEC (FPLP) data may be delivered over a secondary supplemental path.

Without resorting to re-transmissions, the receiving client may be configured to seamlessly reconstruct (recover) missing/unacceptably delayed payload data using FEC data (the information related to the payload recovery data) before the application layer can notice (and react to) an error in the payload data flow (see Fig. 2b).

In an exemplary embodiment called "Ultra-Low Delay LTE using Coded Wi-Fi", payload data sent over LTE may be protected via protection information i.e. FEC data (information related to payload recovery data) sent over a Wi-Fi link. Such LTE enhancement may e.g. be activated in uplink, downlink or symmetrically in both links. Such a scheme may e.g. be implemented using a policy controlled spectrum aggregation framework. For example, a network-resident service might be used for managing radio interface usage throughout an administrative domain, using central optimized decisions based on network-wide information and operator policies.

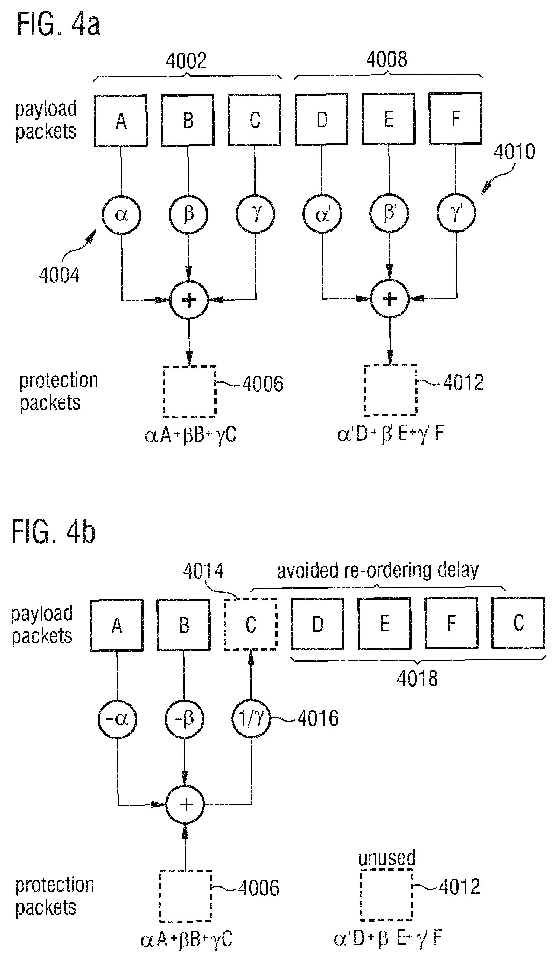

The FEC data may be generated as weighted random linear combinations of multiple payload data packets (see Fig. 4a). The multiplicative weights for packet combining may be selected at random in an identical, independent, uniform manner, for example. The decoding of a missing payload packet may be performed in real time by using Gaussian elimination (see Fig. 4b), e.g. by the control module 24.

Fig. 4a illustrates a formation of FEC packets using random linear codes. Payload packet groups A, B, C 4002 and D, E, F 4008 (each containing three payload packets) are multiplied by weights *α, β, γ* 4004 and *α', β', γ'* 4008 and added to result in protection packages *αA* + *βB* + *γC* 4006 and *α'D* + *β'F* + *γ'F* 4012. Fig. 4b illustrates a recovery of a delayed payload packet using FEC packets. The payload packets arrive in order, bar C 4014, which is at the end of a sequence DEFC 4018. Reverse factor 1/γ 4016 is used to reconstruct C 4014 from the protection package 4006, while protection package 4012 is unused.

The compression effect of packet combining may reduce the FEC overhead. For example, for every N payload packets, one FEC packet may be generated from said N payload packets and sent over the secondary protection link. The overhead (e.g. number of payload recovery packets per payload packet) may define the strength of the encoding protection - payload data duplication over the protection link occurs for N = 1. The encoding protection may be applicable to any type of transport-layer protocol.

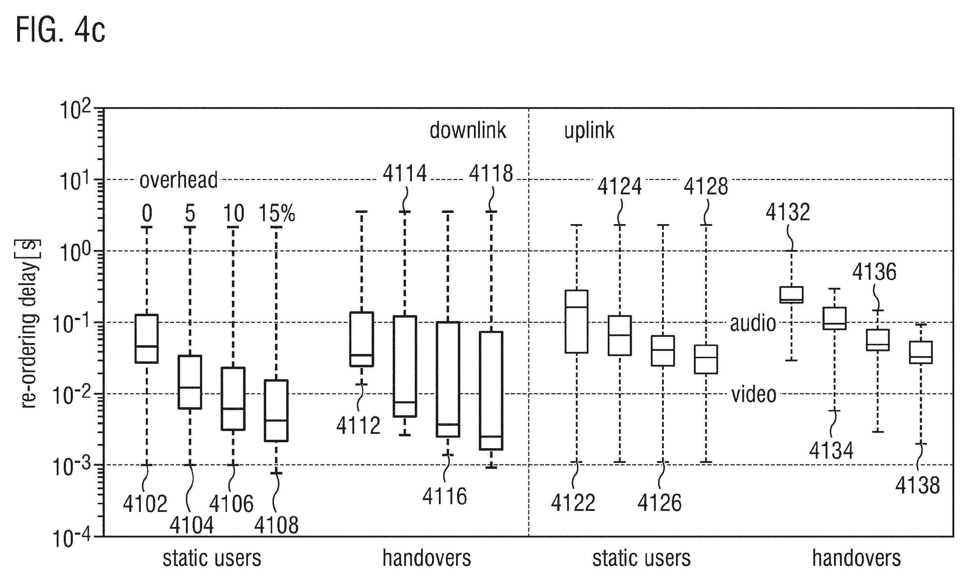

Fig. 4c shows a diagram of a data re-ordering delay as function of forward packet-level protection overhead as measured in live small-cell LTE deployments for static and mobile users. Fig. 4c shows an achievable reduction of data re-ordering delay due to transmission failures assuming correct congestion control without buffer overflows. Propagation delay and physical transmission duration - fixed non-controllable quantities - may be added with the re-ordering delay to obtain the total end-to-end delay. It may be observed that in at least some embodiments, it may be possible to meet data delivery deadlines for interactive audio and video services (100ms and 10ms, respectively). Importantly, even less than 5% overhead may be sufficient to meet this goal, making it a commercially viable technology.

Fig. 4c shows a re-ordering delay 4102; 4104; 4106 and 4108 at 0%, 5%, 10% and 15% overhead, respectively, in downlink for static users. Fig. 4c further shows a re-ordering delay 4112; 4114; 4116 and 4118 at 0%, 5%, 10% and 15% overhead, respectively, in downlink for handover-affected users. Fig. 4c further shows a re-ordering delay 4122; 4124; 4126 and 4128 at 0%, 5%, 10% and 15% overhead, respectively, in uplink for static users. Fig. 4c shows a re-ordering delay 4132; 4134; 4136 and 4138 at 0%, 5%, 10% and 15% overhead, respectively, in uplink for handover-affected users.

Single-flow protection of the above type may be generalized into multi-flow protection in which FEC packets are generated by randomly linearly combining packets scheduled for transmission over multiple parallel primary links. In this way, an outage on any of the primary links might be seamlessly recovered.

In case of connection-less sessions such as UDP streams (e.g. Skype), payload and FEC data may theoretically sent also over non-exclusive links but queuing in shared queues may typically cause correlated outages.

The above example can be readily extended by the above design options on congestion control and path selection/scheduling.

In general, embodiments may provide an approach to aggregating excess/federated bandwidth of unreliable wireless links into a reliable virtual connection, which may be enabled by a software update of user devices and operator proxies such Split-TCP proxies - connections from external networks are nowadays typically ended at the cellular network edge and extended over internal highly optimized tunnel connections.

While access to (free) WiFi may seamlessly improve the subscriber experience of paid services, from the network point of view, embodiments may allow leveraging multi-technological assets of an operator, as well as enabling novel services at minimum costs by exploiting spatial diversity and encoding redundancy. These characteristics may be common in current networks and expected to even form the basis of next-generation networks to compensate for poor propagation properties of mm-wave carriers. Ongoing small-cell densification and deployment of dual connectivity/carrier aggregation/supplemental downlink features in LTE networks may improve a feasibility of embodiments.

The operator can also achieve operating expense reduction by more efficient resource management as protected priority traffic may be offloaded to suboptimum connections.

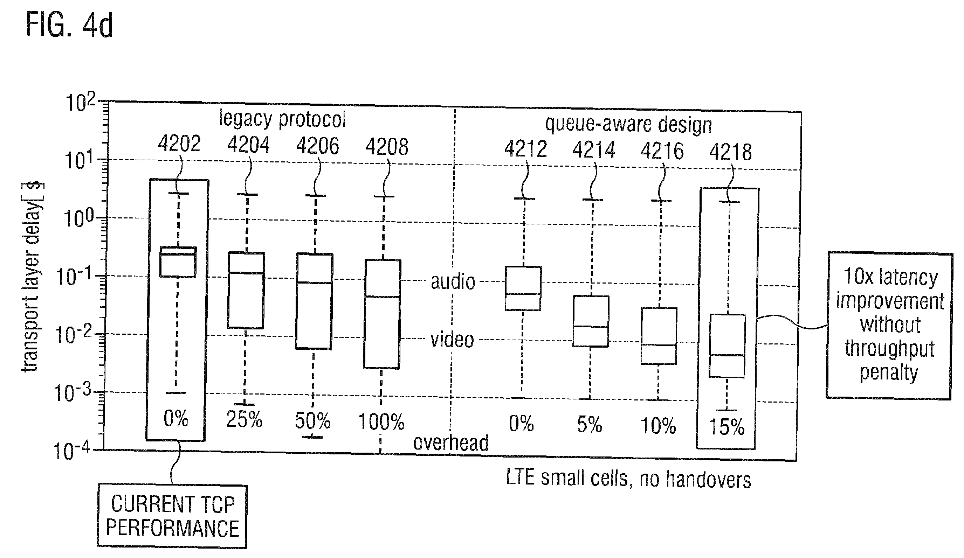

Fig. 4d shows the achievable reduction of data re-ordering delay due to transmission failures assuming the proposed congestion control without buffer overflows. Propagation delay and physical transmission duration - fixed non-controllable quantities - may be added with the re-ordering delay to obtain the total end-to-end delay.

Fig. 4d shows a further diagram of data re-ordering delay as function of forward packet-level protection overhead as measured in live small-cell LTE deployments for static and mobile users. Fig. 4d shows a transport-layer delay 4202; 4204; 4206 and 4208 at 0%, 25%, 50% and 100% overhead, respectively, using a legacy protocol. Fig. 4c further shows a transport layer delay 4212; 4214; 4216 and 4218 at 0%, 5%, 10% and 15% overhead, respectively, using a queue-aware (buffer state-aware) design. Both sets of values are based on LTE small cells with no handovers.

It can be observed that in at least some embodiments, it may be possible to meet data delivery deadlines for interactive audio and video services (100ms and 10ms, respectively). Importantly, less than 5% overhead may be sufficient to meet this goal.

In some embodiments, the first wireless data channel may comprise a first sub-channel and a second sub-channel. The payload data may comprise two or more payload packets. For example, the control module 14 may be configured to transmit the two or more payload packets via the first sub-channel and the second sub-channel, e.g. all of the two or more payload packets on both channels. Alternatively or additionally, the control module 14 may be configured to split up the two or more payload packets in a first plurality of packets and a second plurality of packets, and transmit the first plurality of packets via the first sub-channel and the second plurality of packets via the second sub-channel. The control module 24 may be configured to receive the payload data via the first sub-channel and via the second sub-channel, e.g. in parallel or as first plurality of packets and second plurality of packets. The control module 14 may be configured to use multi-path TCP for the first sub-channel and second sub-channel, for example.

For example, the control module may be configured to determine two or more payload recovery packets based on the two or more payload packets. In various embodiments, the control module 14 may be configured to determine the information related to the payload recovery data based on the two or more payload packets (e.g. for inter-flow recovery). Alternatively, the control module 14 may be configured to determine a first subset of the two or more payload recovery packets based on the first plurality of packets and a second subset of the two or more payload recovery packets based on the second plurality of packets (e.g. for intra-flow recovery). The control module 24 may be configured to recover the missing or delayed packets based on the two or more payload recovery packets, e.g. the first plurality of packets and the second plurality of packets based on the two or more payload recovery packets and/or payload packets of the first plurality of packets based on the first subset of the two or more recovery packets and payload packets of the second plurality of packets based on the second subset of the two or more recovery packets. The first subset and the second subset of the two or more recovery packets may be disjoint, for example.

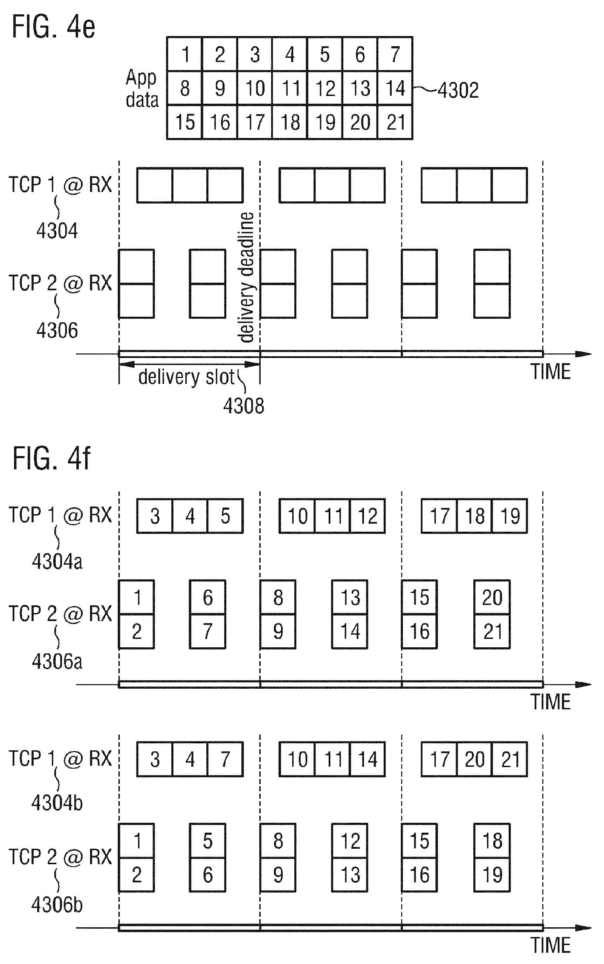

Fig. 4e illustrates an exemplary embodiment. Fig. 4e illustrates payload data 4302 comprising payload packets 1-21 of application data to be sent by a transmitter. On the receiver side, two TCP connections 4304 and 4306 may be open from the transmitter to the receiver. The two TCP connection 4304 and 4306 may correspond to the first and second sub-channels, for example. TCP connections 4304a-d and 4306a-d of subsequent figures 4f-h may correspond to the two TCP connections 4304 and 4306. Empty boxes represent time slots in which the transmitter (TX) assumes that receiver (RX) will receive one packet. Such input may be be used for TX scheduling decisions, e.g. comprised in the buffer-related information.

Fig. 4f illustrates two viable distributions of the payload packets on the two sub-channels. To meet quality-of-service demands, the TX may split up the payload packets into a first, a second and a third group and may require them to be delivered in the corresponding time slot. Within each group, data can be scheduled arbitrarily, e.g. as in 4304a 4306a (first plurality of packets on the first sub-channel 4304a, and second plurality of packets on the second sub-channel 4306, with the first plurality of packets comprising payload packets 3-5, 10-12 and 17-19, and the second plurality of packets comprising the remaining payload packets. 4304b, 4306b show an alternative distribution, with the first plurality of packets comprising payload packets 3, 4, 7, 10 ,11, 14, 17, 20 and 21.

Intra-flow protection may refer to an inclusion of forward-error correction (FEC) data within a flow of payload data (or a time-parallel transmission of it, e.g. via the second wireless data channel). For example, for every N payload packets of payload data of a given flow *F*1, M packets of FEC data (recovery packets), generated from said N payload packets of payload data, may be sent within the same flow F1.

Inter-flow protection may refer to the case of multiple flows *Fx* delivering different sets (e.g. first and second plurality) of payload packets whereby FEC data is delivered to jointly protect the multiple flows *Fx.*

For example, the inter-flow FEC data may be delivered over a (best-effort) flow Fy (e.g. the second wireless data channel) independent with respect to. flows *Fx* (e.g. of the first wireless data channel). Alternatively or additionally, the inter-flow FEC may be generated from payload data that may be sent over different flows *Fx* but is mean to arrive within (approximately) the same time frame (e.g., the payload packets may form a consecutive sequence of data in the source data file delivered over the parallel flows *Fx*). Alternatively or additionally, independent intra-flow FEC may be present at flow *Fx* and, optionally, its amount may be modified (e.g., reduced) as function of the amount of inter-flow FEC (e.g., to replace *X* intra-flow FEC packets by *Y* intra-flow FEC packets). Alternatively or additionally, connection/flow-level sequence numbers may be introduced to enable describing what payload data the inter/intra-flow FEC is respectively associated with given the transmission of delivery flows *Fx* / *Fy.*

In various embodiments, the control module 14 may be configured to determine information related to in-line payload recovery data based on the payload data. The in-line payload recovery data may be transmitted in addition to the information related to the payload recovery data. The control module 14 may be configured to transmit the information related to the in-line payload recovery data via the at least one interface 12 on the first wireless data channel. The control module 14 may be configured to adapt a quantity of the information related to the payload recovery data and/or a quantity of the information related to the in-line payload recovery based on the information related to the in-line payload recovery data. For example, the control module 14 may be configured to determine the information related to the payload recovery data based on a quantity of the information related to the in-line payload recovery data. For example, the more in-line payload recovery data the control module 14 determines, the less payload recovery data may be required, and vice versa.

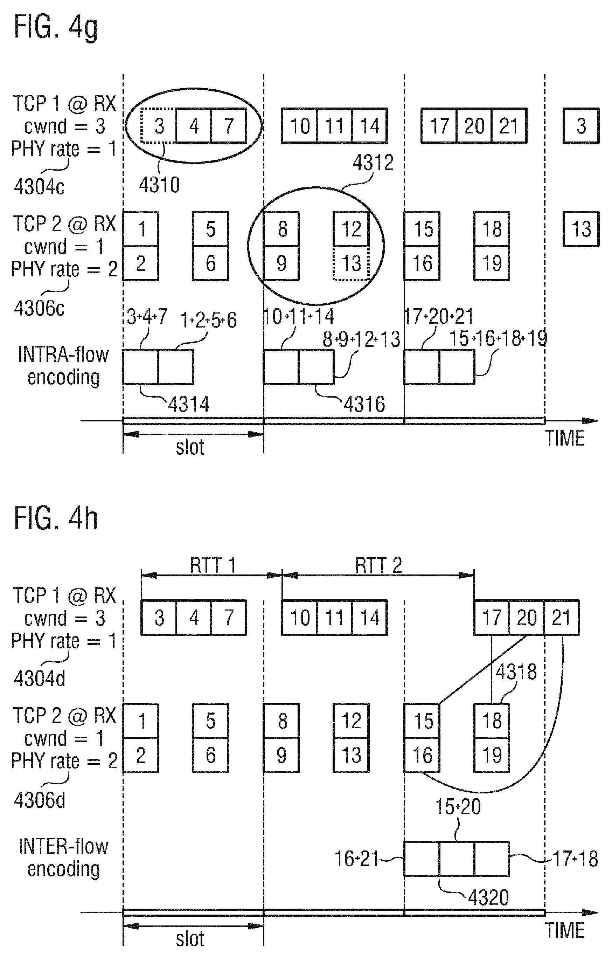

Wireless channels may cause data loss, which may conventionally require re-transmissions and may lead to out of order delivery. Intra/inter-flow protection by forward-error correction (FEC) based on linear combinations of protected payload data may be used for instantaneous data recovery of lost / excessively delayed payload data. In Fig. 4g, data packets 4310 and 4312 are lost on first and second sub-channels 4304c, 4306c. In intra-flow FEC, packets may be recovered within the same sub-channel, e.g. payload recovery packet 4314 and payload packets 4 and 7 may be used to recover missing packet 3 4310 and payload recovery packet 4316 and payload packets 8, 9 and 12 may be used to recover payload packet 13 4312.

Poor multi-flow scheduling and link capacity estimation may be an additional source of out-of-order data delivery. Inter-flow protection may be used to enable that multi-path data that is meant to arrive together (data in the same group) may indeed arrive together (within the required delivery deadlines). Fig. 4h illustrates an illustrative embodiment of inter-flow FEC. Payload recovery packets 4320 on the second sub-channel 4306d may be used to recover payload packets 4318 of the first and second plurality of payload packets on the first sub-channel 4304d within a time-slot.

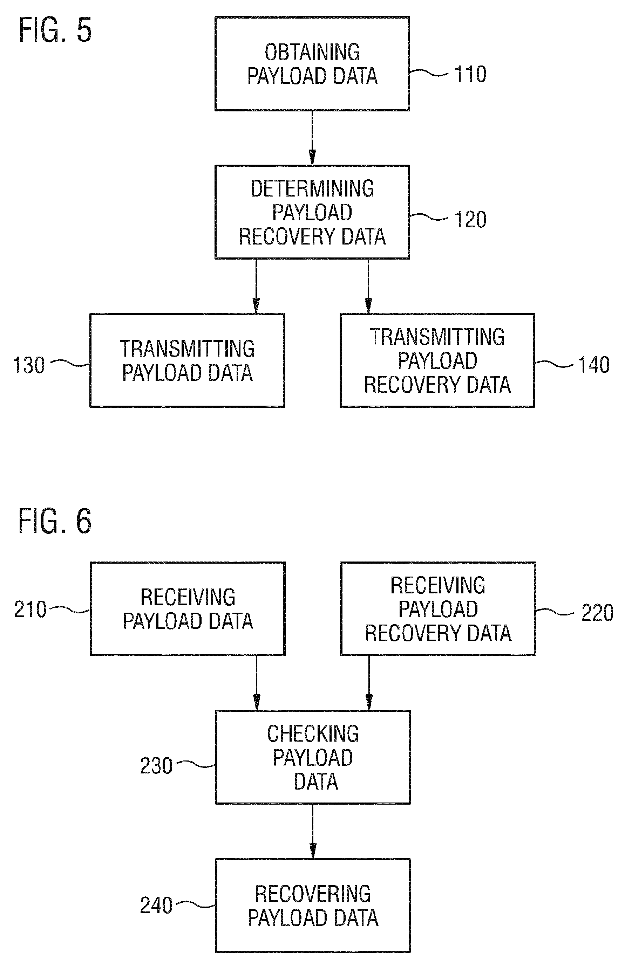

Fig. 5 illustrates a flow chart of an embodiment of a method for transmitting payload data using a first wireless data channel and information related to payload recovery data using a second wireless data channel. The method comprises obtaining 110 the payload data. The method further comprises determining 120 the information related to payload recovery data based on the payload data. The method further comprises transmitting 130 the payload data via the first wireless data channel and the information related to payload recovery data via the second wireless data channel.

Fig. 6 illustrates a flow chart of an embodiment of a method for receiving payload data using a first wireless data channel and information related to payload recovery data using a second wireless data channel. The method comprises receiving 210 the payload data via the first wireless data channel. The payload data comprises one or more payload packets. The method further comprises receiving 220 the information related to the payload recovery data via the second wireless data channel. The method further comprises checking 230 the payload data for missing or delayed payload packets. The method further comprises recovering 240 the missing or delayed packets of the payload data based on the information related to the payload recovery data.

Embodiments further provide a computer program having a program code for performing one of the methods when the computer program is executed on a computer or processor.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks labeled as "means", "means for controlling", "means for transceiving", etc., may be provided through the use of dedicated hardware, such as "a processor", "a controller", "a transceiver" etc. as well as hardware capable of executing software in association with appropriate software. Moreover, any entity described herein as "means", may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. Apparatus (10), configured to transmit payload data using a first wireless data channel and information related to payload recovery data using a second wireless data channel, the apparatus (10) comprising
at least one interface (12) configured to communicate via the first wireless data channel and via the second wireless data channel; and
a control module (14) configured to:
control the at least one interface (12)
obtain the payload data,
determine the information related to payload recovery data based on the payload data, and
transmit the payload data via the at least one interface (12) and the first wireless data channel and the information related to payload recovery data via the at least one interface (12) and the second wireless data channel.

2. The apparatus (10) according to claim 1, wherein the control module (14) is further configured to determine buffer-related information of a network entity configured to communicate via the first wireless data channel, and wherein the control module (14) is further configured to transmit the payload data based on the buffer-related information of the network entity.

3. The apparatus (10) according to claim 1, wherein the payload data comprises one or more payload packets, and wherein the control module (14) is configured to determine one or more payload recovery packets for the information related to the payload recovery data, wherein a payload recovery packet comprises data recovery information for at least one payload packet.

4. The apparatus (10) according to claim 3, wherein the control module (14) is configured to determine the one or more payload recovery packets based on a weighted random linear combination of the one or more payload packets or based on a logic function based on the one or more payload packets.

5. The apparatus (10) according to claim 1, wherein the control module (14) is configured to determine information related to in-line payload recovery data based on the payload data, wherein the control module (14) is configured to transmit the information related to the in-line payload recovery data via the at least one interface (12) on the first wireless data channel, and wherein the control module (14) is configured to adapt a quantity of the information related to the payload recovery data and/or a quantity of the information related to the in-line payload recovery based on the information related to the in-line payload recovery data.

6. The apparatus (10) according to claim 1, wherein the control module (14) is configured to transmit the information related to the payload recovery data if a traffic indicator of the second wireless data channel indicates an availability of data channel bandwidth for the transmission of the information related to the payload recovery data.

7. The apparatus (10) according to claim 1, wherein the control module (14) is configured to transmit the information related to the payload recovery data if the first wireless data channel and the second wireless data channel use at least partly different transmission resources.

8. The apparatus (10) according to claim 1, wherein the at least one interface (12) comprises a first wireless interface (12a), configured to communicate via the first wireless data channel and a second wireless interface (12b), configured to communicate via the second wireless data channel, and wherein the control module (14) is configured to transmit the payload data via the first wireless interface (12a) and to transmit the information related to the payload recovery data via the second wireless interface (12b).

9. The apparatus (10) according to claim 1, wherein the control module (14) is configured to switch the transmission of the payload data to the second wireless data channel and the transmission of the information related to the payload recovery data to the first wireless data channel based on transmission properties of the first wireless data channel and based on transmission properties of the second wireless data channel.

10. Apparatus (20), configured to receive payload data using a first wireless data channel and information related to payload recovery data using a second wireless data channel, the apparatus (20) comprising
at least one interface (22), configured to receive the payload data via the first wireless data channel and the information related to the payload recovery data via the second wireless data channel, wherein the payload data comprises one or more payload packets; and
a control module (24), configured to:
control the at least one interface (22),
check the payload data for missing or delayed payload packets, and
recover the missing or delayed packets of the payload data based on the information related to the payload recovery data.

11. The apparatus (20) according to claim 10, wherein the information related to the payload recovery data comprises one or more payload recovery packets, wherein the control module (24) is configured to recover at least one missing or delayed payload packet of the one or more payload packets based on the one or more payload recovery packets.

12. The apparatus (20) according to claim 11, wherein the one or more payload recovery packets are based on a weighted random linear combination of the one or more payload packets, and wherein the control module (24) is configured to recover the at least one missing or delayed payload packet based on a Gaussian elimination based on the one or more payload packets and based on the one or more payload recovery packets.

13. Method for transmitting payload data using a first wireless data channel and information related to payload recovery data using a second wireless data channel, the method comprising
obtaining (110) the payload data;
determining (120) the information related to payload recovery data based on the payload data;
transmitting (130) the payload data via the first wireless data channel; and transmitting (140) the information related to payload recovery data via the second wireless data channel.

14. Method for receiving payload data using a first wireless data channel and information related to payload recovery data using a second wireless data channel, the method comprising
receiving (210) the payload data via the first wireless data channel, wherein the payload data comprises one or more payload packets;
receiving (220) the information related to the payload recovery data via the second wireless data channel;
checking (230) the payload data for missing or delayed payload packets; and recovering (240) the missing or delayed packets of the payload data based on the information related to the payload recovery data.

15. A computer program having a program code for performing the method of one of the claims 13 or 14 when the computer program is executed on a computer or processor.

## Amended claims

### Amended claims in accordance with Rule 137(2) EPC.

1. Apparatus (10), configured to transmit payload data using a first wireless data channel and information related to payload recovery data using a second wireless data channel, the apparatus (10) comprising
at least one interface (12) configured to communicate via the first wireless data channel and via the second wireless data channel; and
a control module (14) configured to:
control the at least one interface (12)
obtain the payload data,
determine the information related to payload recovery data based on the payload data, and
transmit the payload data via the at least one interface (12) and the first wireless data channel and the information related to payload recovery data via the at least one interface (12) and the second wireless data channel,
wherein the control module (14) is configured to transmit the information related to the payload recovery data if the first wireless data channel and the second wireless data channel use at least partly different transmission resources, wherein the information related to the payload recovery data is not transmitted if the first and second wireless data channels share a wireless resource or a network entity providing less than a required data transmission bandwidth.

2. The apparatus (10) according to claim 1, wherein the control module (14) is further configured to determine buffer-related information of a network entity configured to communicate via the first wireless data channel, and wherein the control module (14) is further configured to transmit the payload data based on the buffer-related information of the network entity.

3. The apparatus (10) according to claim 1, wherein the payload data comprises one or more payload packets, and wherein the control module (14) is configured to determine one or more payload recovery packets for the information related to the payload recovery data, wherein a payload recovery packet comprises data recovery information for at least one payload packet.

4. The apparatus (10) according to claim 3, wherein the control module (14) is configured to determine the one or more payload recovery packets based on a weighted random linear combination of the one or more payload packets or based on a logic function based on the one or more payload packets.

5. The apparatus (10) according to claim 1, wherein the control module (14) is configured to determine information related to in-line payload recovery data based on the payload data, wherein the control module (14) is configured to transmit the information related to the in-line payload recovery data via the at least one interface (12) on the first wireless data channel, and wherein the control module (14) is configured to adapt a quantity of the information related to the payload recovery data and/or a quantity of the information related to the in-line payload recovery data based on the information related to the in-line payload recovery data.

6. The apparatus (10) according to claim 1, wherein the control module (14) is configured to transmit the information related to the payload recovery data if a traffic indicator of the second wireless data channel indicates an availability of data channel bandwidth for the transmission of the information related to the payload recovery data.

7. The apparatus (10) according to claim 1, wherein the at least one interface (12) comprises a first wireless interface (12a), configured to communicate via the first wireless data channel and a second wireless interface (12b), configured to communicate via the second wireless data channel, and wherein the control module (14) is configured to transmit the payload data via the first wireless interface (12a) and to transmit the information related to the payload recovery data via the second wireless interface (12b).

8. The apparatus (10) according to claim 1, wherein the control module (14) is configured to switch the transmission of the payload data to the second wireless data channel and the transmission of the information related to the payload recovery data to the first wireless data channel based on transmission properties of the first wireless data channel and based on transmission properties of the second wireless data channel.

9. Apparatus (20), configured to receive payload data using a first wireless data channel and information related to payload recovery data using a second wireless data channel, wherein the information related to the payload recovery data is not transmitted if the first and second wireless data channels share a wireless resource or a network entity providing less than a required data transmission bandwidth, the apparatus (20) comprising
at least one interface (22), configured to receive the payload data via the first wireless data channel and the information related to the payload recovery data via the second wireless data channel, wherein the payload data comprises one or more payload packets; and
a control module (24), configured to:
control the at least one interface (22),
check the payload data for missing or delayed payload packets, and
recover the missing or delayed packets of the payload data based on the information related to the payload recovery data.

10. The apparatus (20) according to claim 9, wherein the information related to the payload recovery data comprises one or more payload recovery packets, wherein the control module (24) is configured to recover at least one missing or delayed payload packet of the one or more payload packets based on the one or more payload recovery packets.

11. The apparatus (20) according to claim 10, wherein the one or more payload recovery packets are based on a weighted random linear combination of the one or more payload packets, and wherein the control module (24) is configured to recover the at least one missing or delayed payload packet based on a Gaussian elimination based on the one or more payload packets and based on the one or more payload recovery packets.

12. Method for transmitting payload data using a first wireless data channel and information related to payload recovery data using a second wireless data channel, the method comprising
obtaining (110) the payload data;
determining (120) the information related to payload recovery data based on the payload data;
transmitting (130) the payload data via the first wireless data channel; and
transmitting (140) the information related to payload recovery data via the second wireless data channel if the first wireless data channel and the second wireless data channel use at least partly different transmission resources, wherein the information related to the payload recovery data is not transmitted if the first and second wireless data channels share a wireless resource or a network entity providing less than a required data transmission bandwidth.

13. Method for receiving payload data using a first wireless data channel and information related to payload recovery data using a second wireless data channel, wherein the information related to the payload recovery data is not transmitted if the first and second wireless data channels share a wireless resource or a network entity providing less than a required data transmission bandwidth, the method comprising
receiving (210) the payload data via the first wireless data channel, wherein the payload data comprises one or more payload packets;
receiving (220) the information related to the payload recovery data via the second wireless data channel;
checking (230) the payload data for missing or delayed payload packets; and
recovering (240) the missing or delayed packets of the payload data based on the information related to the payload recovery data.

14. A computer program having a program code for performing the method of one of the claims 12 or 13 when the computer program is executed on a computer or processor.
